# EUROPEAN PATENT APPLICATION

(11) **EP 4 709 083 A1**
(43) Date of publication of application: **11.03.2026**
(21) Application number: 24198518.3
(22) Date of filing: 04.09.2024
(51) Int. Cl.: H10D 30/66, H10D 30/01, H10D 64/00, H10D 64/23

(54) **TRANSISTOR DEVICE AND METHOD FOR FABRICATING SAME**

(71) Applicant: Infineon Technologies Austria AG, 9500 Villach (AT)
(72) Inventor: TEGEN, Stefan, 01109 Dresden (DE); OPHERDEN, Daryna, 01454 Ullersdorf (DE)
(74) Representative: JENSEN & SON

(57) **Abstract**

In an embodiment, a transistor device is provided that comprises a semiconductor substrate having a first major surface, an active area and an edge region that laterally surrounds the active area, one or more trenches located in the first major surface in the active area, a field plate in the lower portion of the trench and a gate electrode in the upper portion of the one or more trenches above the field plate and a first self-aligned contact into the first major surface of the semiconductor substrate laterally adjacent to and spaced apart from the one or more trenches. In the active area, an upper surface of the gate electrode is in contact with a first electrically insulating layer only. The first electrically insulating layer protrudes above the first major surface and has an upper surface and side walls that extend from the upper surface to the first major surface of the semiconductor substrate and wherein a second electrically insulating layer is located on the side walls and the upper surface of the first electrically insulating layer is free of the second electrically insulating layer.

## Description

### BACKGROUND

Transistors used in power electronic applications may be fabricated with silicon (Si) semiconductor materials. Common transistor devices for power applications include Si CoolMOS^{™}, Si Power MOSFETs, and Si Insulated Gate Bipolar Transistors (IGBTs). Contacts are formed to the transistor device, for example to contact the gate electrode and the source and body regions.

US 9,029,220 B2 describes a method of manufacturing a semiconductor device with self-aligned contact plugs. Semiconductor oxide pillars are selectively grown on semiconductor mesas between precursor structures that extend from a main surface into a semiconductor substrate. Spaces between the semiconductor oxide pillars are filled with one or more auxiliary materials to form alignment plugs in a vertical projection of the precursor structures. The semiconductor oxide pillars are removed selectively against the alignment plugs. Contact spacers are provided along sidewalls of the alignment plugs. Between opposing ones of the contact spacers contact plugs are provided directly adjoining the semiconductor mesas. The contact plugs are self-aligned to the semiconductor mesas and allow a further reduction of the lateral dimensions of the semiconductor mesas without recessing the semiconductor mesas.

It is desirable to provide a transistor device and methods for fabricating contacts to a transistor device which provide an accurate placement of the contacts and which are simpler to perform.

### SUMMARY

In an embodiment, a transistor device is provided that comprises a semiconductor substrate having a first major surface, an active area and an edge region that laterally surrounds the active area, one or more trenches located in the first major surface in the active area, a field plate in the lower portion of the one or more trenches and a gate electrode in the upper portion of the one or more trenches above the field plate and a first self-aligned contact into the first major surface of the semiconductor substrate, the first self-aligned contact being located laterally adjacent to and spaced apart from the one or more trenches. In the active area, an upper surface of the gate electrode is in contact with a first electrically insulating layer only. The first electrically insulating layer protrudes above the first major surface of the semiconductor substrate and has an upper surface and side walls that extend from the upper surface to the first major surface of the semiconductor substrate. A second electrically insulating layer is located on the side walls of the first electrically insulating layer. The upper surface of the first electrically insulating layer is free of the second electrically insulating layer.

In an embodiment, a method for fabricating a contact to a semiconductor device is provided. The method comprises providing a semiconductor substrate comprising a first major surface, forming a first hard mask located on the first major surface, forming a first opening in the first hard mask, forming one or more trenches located in the first major surface of the semiconductor substrate in the first opening of the first hard mask, the one or more trenches comprising a side wall and base, forming a field plate in the lower portion of the one or more trench and a gate electrode in the upper portion of the one or more trenches above the field plate, wherein the gate electrode is exposed in the first opening of the first hard mask, depositing a first electrically insulating material into the first opening in the first hard mask, selectively removing the first hard mask such that a portion of the first electrically insulating layer that remains protrudes above the first major surface of the semiconductor substrate, depositing a second electrically insulating layer over the first major surface and over the portion of the first electrically insulating layer, performing an etch process and forming a first recess that extends through the second electrically insulating layer and into the first major surface of the semiconductor substrate adjacent the one or more trenches, and inserting electrically conductive material into the first recess to form a contact to the semiconductor substrate.

In an embodiment, a method of forming a contact to an active area of a semiconductor substrate and to an edge region of the semiconductor substrate is provided. The method comprises providing a semiconductor substrate having a first major surface, an active area and an edge region that laterally surrounds the active area, forming portions of a first electrically insulating layer above trenches in the semiconductor substrate in at least the active area, forming a second electrically insulating layer over the portions of the first electrically insulating layer and over the first major surface in the active area and in the edge region, forming a third electrically insulating layer on the first electrically insulating layer in the edge region only, forming a structured soft mask on the third electrically insulating layer and removing the third electrically insulating layer above at least one discrete region of the first major surface of the semiconductor substrate in the edge region, performing an etch process and removing the third electrically insulating layer and the second electrically insulating layer from the at least one discrete region and exposing an underlying structure in the edge region to form a non-aligned contact recess in the edge region, and, adjacent to the portions of the first electrically insulating layer, removing the second electrically insulating layer and a portion of the semiconductor substrate to form a self-aligned contact recess in the active area, wherein the portions of the first electrically insulating layer above the trenches in the semiconductor substrate act as a mask, and inserting electrically conductive material into the non-aligned contact recess in the edge region and into the self-aligned contact recess in the active area to form a self-aligned contact to an active area and a non-aligned contact to an edge region of a semiconductor substrate.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1 illustrates a cross-sectional view of a transistor device.
Figure 2, which includes figures 2A to 2E, illustrates further views of the transistor device of Figure 1.
Figure 3, which includes figures 3A to 3R, illustrates a method of fabricating contacts to a semiconductor substrate.
Figure 4 illustrates alternative structures for the field plate of the transistor device of figures 1 and 2.
Figure 5 illustrates a flow diagram of a method for fabricating a contact to an active area of a semiconductor device.
Figure 6 illustrates a flow diagram of a method for fabricating a contact to an active area and to an edge region of a semiconductor device.
Figure 7 illustrates a flow diagram of a method for fabricating a contact to an active area of a semiconductor device.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

As used herein, various device types and/or doped semiconductor regions may be identified as being of n type or p type, but this is merely for convenience of description and not intended to be limiting, and such identification may be replaced by the more general description of being of a "first conductivity type" or a "second, opposite conductivity type" where the first type may be either n or p type and the second type then is either p or n type.

The Figures illustrate relative doping concentrations by indicating "-" or "+" next to the doping type "n" or "p". For example, "n " means a doping concentration which is lower than the doping concentration of an "n"-doping region while an "n⁺"-doping region has a higher doping concentration than an "n"-doping region. Doping regions of the same relative doping concentration do not necessarily have the same absolute doping concentration. For example, two different "n"-doping regions may have the same or different absolute doping concentrations.

In some embodiments, the vertical transistor device is a MOSFET (Metal Oxide Semiconductor Field Effect Transistor) device, an insulated gate bipolar transistor (IGBT) device or a Bipolar Junction Transistor (BJT).

The electrodes or terminals of the transistor device are referred to herein as source, drain and gate. As used herein, these terms also encompass the functionally equivalent terminals of other types of transistor devices, such as an insulated gate bipolar transistor (IGBT). For example, as used herein, the term "source" encompasses not only a source of a MOSFET device and of a superjunction device but also an emitter of an insulator gate bipolar transistor (IGBT) device and an emitter of a Bipolar Junction Transistor (BJT) device, the term "drain" encompasses not only a drain of a MOSFET device or of a superjunction device but also a collector of an insulator gate bipolar transistor (IGBT) device and a collector of a BJT device, and the term "gate" encompasses not only a gate of a MOSFET device or of a superjunction device but also a gate of an insulator gate bipolar transistor (IGBT) device and a base of a BJT device.

The present disclosure addresses forming contacts to a semiconductor device such as a transistor device and forming a contact in the active area of a transistor device.

Some transistor devices comprise a plurality of transistor cells, each including a trench in which a gate electrode and a field plate are formed. The trenches are separated by a mesa in which the source and body region of the transistor device are formed. A contact is formed to the source and body region in the mesa. Typically, these contacts are formed by means of lithography. A photolithographic mask is used to define the width and the position of the contacts to the mesa in the active area. Additionally, this mask can be used to define the width and position of contacts located in the edge region, for example contacts to the field plate, gate electrode, and to the drain potential which are located in the edge region.

The minimum width of the contacts may be in practice limited by the lithographic tools available which can lead to a variation in the width and position across the wafer. The mask for forming the contacts may align to the mask, which defines the position of the trenches and the mesa. There may be an alignment error which results in a misalignment of a contact with respect to the mesa. For example, the contact may not be positioned at the centre of the mesas. Width variations of the contacts or their misalignment can cause electrical problems. For example, the threshold voltage (VT), the RON (on-state resistance), the gate capacitance (QGS, QGD), avalanche robustness and other device parameters vary with the width of the contacts and their position on the mesa.

To address these issues, the present disclosure provides a method for fabricating self-aligned contacts in the active area of a device, e.g. a transistor device. The gate structure is used to create a topology that is used to form these self-aligned contacts to the mesa. The gate structure may be used in combination with a nitride layer that acts as an etch stop. The contacts to the field plate and gate electrode, and the contacts to the drain may be fabricated by means of lithography and be non-aligned contacts. The self-aligned contacts to the mesas in the active area and the non-aligned contacts in the edge region may be fabricated using some of the same processes so as to simplify and speed up manufacturing of the transistor device.

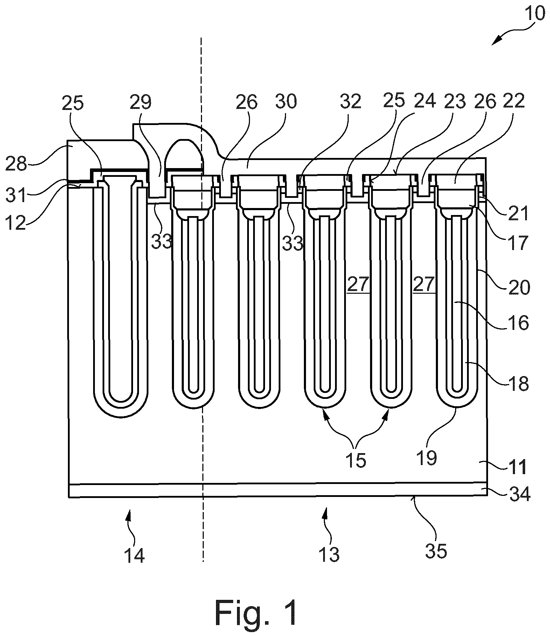

Figure 1 illustrates a cross-sectional view of a transistor device 10 which comprises a semiconductor substrate 11 having a first major surface 12. The semiconductor substrate 11 comprises an active area 13 and an edge region 14 that laterally surrounds the active area 13. One or more trenches 15 are located in the first major surface 12 in the active area 13. A field plate 16 is located in the lower portion of the trench 15 and a gate electrode 17 is located in the upper portion of the trench 15 above the field plate 16. The field plate 16 is electrically conductive and is electrically insulated from the semiconductor substrate 11 by a first dielectric material 18 that lines the base 19 and sidewall 20 of the trench 15. The first dielectric material 18 may be called a field dielectric. The first dielectric material 18 may be formed of a single layer or of two sublayers, as shown in figure 1, or more than two sublayers. A portion of the first dielectric material 18, e.g. one of the sublayers, extends between the upper surface of the field plate 16 and lower surface of the gate electrode 17 so as to electrically insulate the gate electrode 17 from the underlying field plate 16. The gate electrode 17 is electrically isolated from the semiconductor substrate 11 by a gate dielectric 21 which is located on the sidewall 20 of the trench 15 and between the sidewall 20 and the gate electrode 17.

The semiconductor substrate 11 may comprise silicon, for example a silicon single crystal wafer or a monocrystalline silicon layer, e.g. an epi layer, that is formed on a base substrate. The silicon substrate may be of the first conductivity type, e.g. n-type. The first insulating material 18 and gate dielectric 21 may comprise silicon oxide. The field plate 16 may be formed of polysilicon and the gate electrode 17 may be formed of polysilicon.

In some embodiments, such as that illustrated in figure 1, the trench 15 has an elongate stripe -like shape in which the length of the trench 15 extends into the plane of the drawing. The length which extends parallel to the first major surface 12 and is greater than its depth from the first major surface 12, which is in turn greater than its width. The sidewall 20 has four subsections, whereby adjoining subsections extend perpendicularly to one another so that in top view, the trench 15 has a substantially rectangular shape.

In the active area 13 of the transistor device 10, an upper surface of the gate electrode 17 is in contact with a first electrically insulating layer 22. The lateral size of the first electrically insulating layer 22 may correspond to the lateral size and shape of the trench 15 at the first major surface 12. The first electrically insulating layer 22 has the form of a plurality of discrete separate regions that are spaced apart from one another. For example, for stripe-like trenches 15 that extend parallel to one another, the first electrically insulating layer 22 has the form of a plurality of separate stripe-like regions that are spaced apart from one another and that extend substantially parallel to one another. The portions of the first electrically insulating layer 22 protrudes above the first major surface 12 of the semiconductor substrate 11 such that its upper surface 23 is located in a plane above the first major surface 12. Sidewalls 24 of the electrically insulating layer 22 extend from the upper surface 23 to the first major surface 12 of the semiconductor substrate 11.

A second electrically insulating layer 25 is located on the sidewalls 24 of the first electrically insulating layer 22. In contrast, the upper surface 23 of the first insulating layer 22 is free of the second insulating layer 25. The transistor device 10 further comprises a first contact 26 which extends into the first major surface 12 of the semiconductor substrate 11 at a position of the first major surface 12 which is laterally adjacent to and spaced apart from the trench 15. The second electrically insulating layer 25 occupies the space on the first major surface 12 between the contact 26 and the first electrically insulating layer 22. The first contact 26 may be a self-aligned contact. The first and second electrically insulating layers 22, 25 may comprise silicon oxide.

The transistor device 10 comprises a plurality of transistor cells, each comprising a trench 15. The trenches 15 extend substantially parallel to one another into the plane of the drawing such that a mesa 27 is formed between adjacent ones of the trenches 15. The self-aligned contact 26 extends from the first major surface 12 into the mesa 27 where it provides a contact to the semiconductor substrate 11 and, in particular, the source region 33 and body region 32 of the transistor device 10. The body region is formed of the second conductivity type, e.g. p-type, if the first conductivity type is n-type. The source region 33 is formed of the first conductivity type and is located on or in the body region 32 and extends to the first major surface 12. The drain region 34 of the transistor device 10 may be provided by a region at the second major surface 35 of the semiconductor substrate 11, which opposes the first major surface 12. The drain region 34 is of the first conductivity type. The contact 26 extends between portions of the second insulating layer 25 which are located on the sidewalls 24 of the portions of first electrically insulating layer 22 that are located above two neighbouring trenches 15.

The contact 26 may also extend into, or be in contact with, a lateral electrically conductive layer 30 that extends over the upper surface of the first electrically insulating layer 22 which is positioned above the gate electrode 17. The lateral electrically conductive layer 30 electrically connects the contacts 26 formed in each of the mesas 27 to one another. The use of the second insulating layer 25, that is positioned on the sidewalls 24 of the first insulating layer 22, in combination with the discrete regions of the first insulating layer 22 provides a mask for forming the recess for the contact 26. When the recess is filled with conductive material, the contact 26 is formed which can be described as a self-aligned contact as the structure of the gate, i.e. the portion of the first electrically insulating layer 22 above the gate electrode 17 in each trench 15, determines the location of the contact 26.

Figure 1 also shows a portion of the edge region 14 that is adjacent to the active area 13. In the edge region 14, the second insulating layer 25 extends over the first major surface and a third insulating layer 28 is arranged on the second insulating layer 25. The third insulating layer 28 is not located in the active area 13. The location of the third electrically insulating layer 28 marks the position of the edge region 14. The edge region 14 comprises a second contact 29 to the semiconductor substrate 11. The second contact 29 may contact the body region 32 at the transition between the active area 13 and the edge region 14.

The second contact 29 extends through the third insulating layer 28 and the second electrically insulating layer 25 and into the semiconductor substrate 11. In contrast, in the active area, the first contact 26 extends only through the second insulating layer 25 into the semiconductor substrate 11. In some embodiments, the second contact 29 is electrically connected to the electrically conductive layer 30 that connects the first contacts 26. In some embodiments, in the edge region 14, a fourth electrically insulating layer 31 is provided which is positioned between the second insulating layer 25 and the third electrically insulating layer 28. The fourth insulating layer 31 may have a composition selected so that it acts as an etch stop such as an etch stop layer (e.g., when etching the second and third electrically insulating layers, 25, 28). For example, the fourth electrically insulating layer 31 may be formed of silicon nitride and the second and third electrically insulating layers, 25, 28 may be formed of silicon oxide.

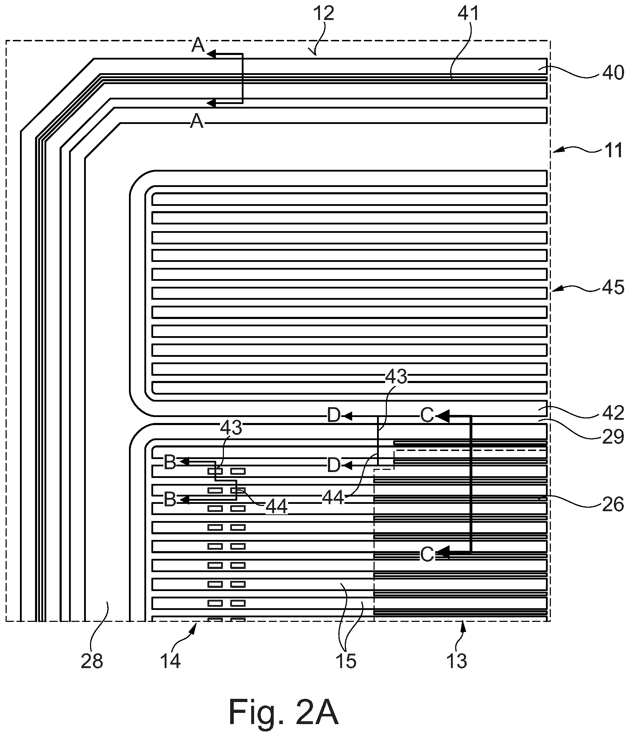

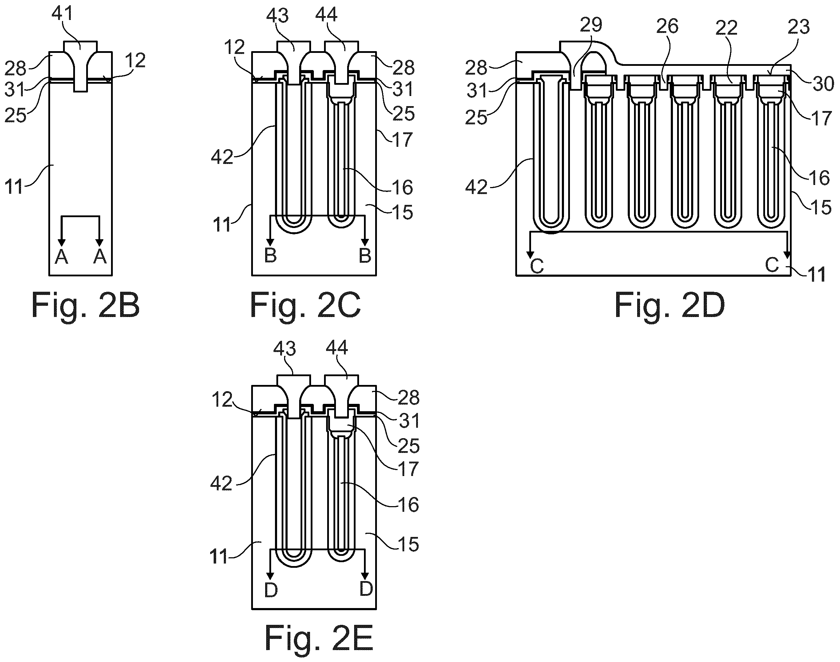

Figure 2, which includes figures 2A to 2E, illustrates views of the transistor device 10. Figure 2A illustrates a top view of a corner region of the semiconductor substrate 11 and illustrates a corner portion of the active region 13 and a corner region of the edge region 14. The edge region 14 is distinguishable from the active region 13 by the presence of the third insulating layer 28 on the first major surface 12.

Referring to the top view of Figure 2A, the active area 13 comprises a plurality of elongate stripe-like trenches 15 which also extend into the edge region 14. A plurality of these stripe -like trenches 15 are laterally surrounded by a continuous trench 42. Whilst the trench 42 is shown as having rounded corners in figure 2A, the corners may alternatively be perpendicular when viewed from above. In the active area 13, the trenches 15 have the structure in the cross-sectional view along the line C- C shown in figure 2A that is illustrated by figure 2D. Figure 2D corresponds to figure 1. In this embodiment, the second contact 29 is located adjacent the outermost active trench 15. The trench 15 extends from the active area 13 into the edge region 14 in order to allow contacts to be formed to the field plate 16 in the lower part of the trench 15 as well as to the gate electrode 17 in the upper part of the trench 15 in that portion of the trench 15 that is located in the edge region 14.

Referring to the top view of figure 2A, the edge region 14 comprises at least one, in this embodiment three, continuous ring-shaped trenches 40 which laterally and continually extend around the periphery of the first major surface 12. The continuous trenches 40 are illustrated as having rounded corners. However, the corners may not be rounded and may form a perpendicular angle between horizontal and vertical section (when viewed from the top). The trenches 40 may be filled with electrically insulating material. A contact 41 is formed between two of the trenches 40. In some embodiments, the trenches 40 may be omitted. The contact 41 is shown in the cross-sectional view of Figure 2B along the line A-A shown in figure 2A, whereby the trenches 40 are omitted in the cross-sectional view of figure 2B. The contact 41 extends through the third electrically insulating layer 28, the fourth electrically insulating layer 31 and the second electrically insulating layer 25 and into the semiconductor substrate 11. The contact 41 may form a drain contact or may be used as a diffusion stopper to hinder diffusion of ions, e.g. from the environment or periphery of the chip, into the active area of the chip. The edge region 14 may include further structures between the active area 13 and the ring-shaped trenches 40, such as filled trenches 45 which are not electrically active and which do not pay any role or at least a rather negligible role in the switching of the transistor device 10. These further structures, e.g. the trenches 45, may be provided to assist the etching processes and planarization by Chemical Mechanical Polishing (CMP), and/or improve the mechanical stability or may comprise test structures.

In the cross-sectional view along the line C-C of figure 2D, it can be seen that trench 42 is without a gate electrode and the conductive field plate 16 extends to above the first major surface 12. An upper surface of field plate 16 may lie in a plane above the plane of the first major surface 12. The upper surface of the field plate 16 may be substantially coplanar with the upper surface 23 of the second insulating layer 22 that is formed above the trenches 15 and on the gate electrode 17. The field plate 16 in the trench 42 is covered by the second insulating layer 25, the fourth insulating layer 31 and the third insulating layer 25.

Figure 2C illustrates a cross-sectional view along line B-B and shows a cross-sectional view of the trenches 15 at a location in the edge region 14 and at a location in which the contacts 43, 44 to the field plate 16 and gate electrode 17 within the trench 15 are formed. The cross-sectional view of Figure 2E represents the cross-sectional view along the line D-D of the outermost trench 15 and continuous trench 42 in the edge region 14.

The contact 43 to the field plate 16 and the contact 44 to the gate electrode 17 within the trench 15 are located in the edge region 14 and in a portion of the trench 15 that extends into the edge region 14. The edge region 14 is distinguishable from the active region 13 by the presence of the third insulating layer 28 on the first major surface 12. As can be seen in the cross-sectional view of figure 2C, the contact 43 to the field plate 16 extends through the third, fourth and second insulating layers 28, 31, 25 and into the conductive material of the field plate 16 located in the trench 16. The contact 44 for the gate electrode 17 also extends through the third, fourth and second electrically insulating layers 28, 31,25 and into the gate electrode 17. It can be seen, that in this portion of the trench 15 that is located in the edge region 14, the first insulating layer 22 is not present, whereas in the portion of the trench 15 which is located in the active region 13, as shown in figure 2D, the first electrically insulating layer 22 covers the gate electrode 17.

The cross-sectional view of Figure 2E represents the cross-sectional view along the line D-D of the outermost trench 15 and continuous trench 42 in the edge region 14at a position in which a contact 43 to the gate electrode 17 in the trench 15is located and in which a contact 44 to the field plate 16 in the continuous trench 42 is located. The contact 43 to the field plate 16 in the trench 42 extends through the third, fourth and second insulating layers 28, 31, 25 and into the conductive material of the field plate 16 located in the trench 16. The contact 44 to the gate electrode 17 in the trench 15 also extends through the third, fourth and second electrically insulating layers 28, 31,25 and into the gate electrode 17.

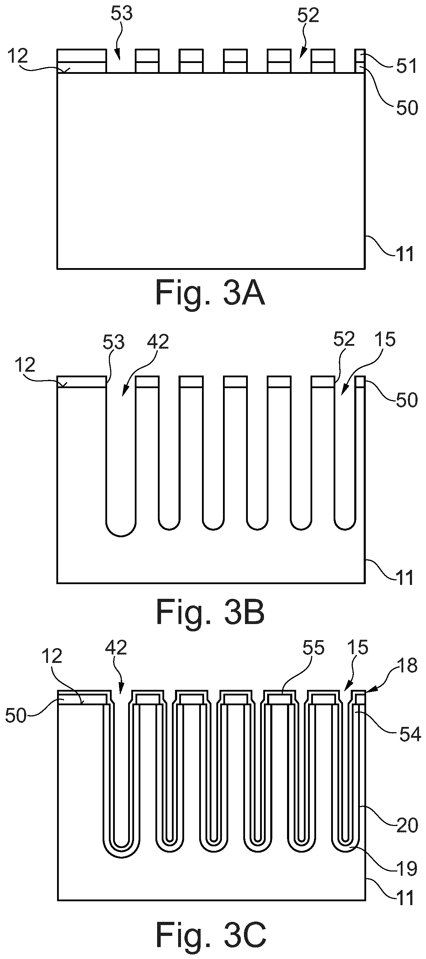

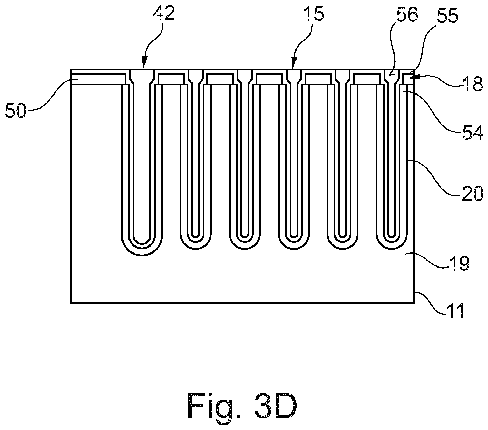

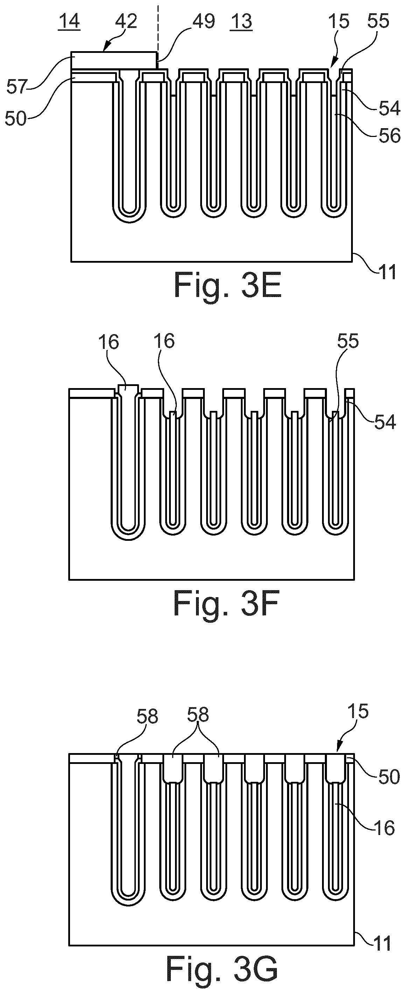

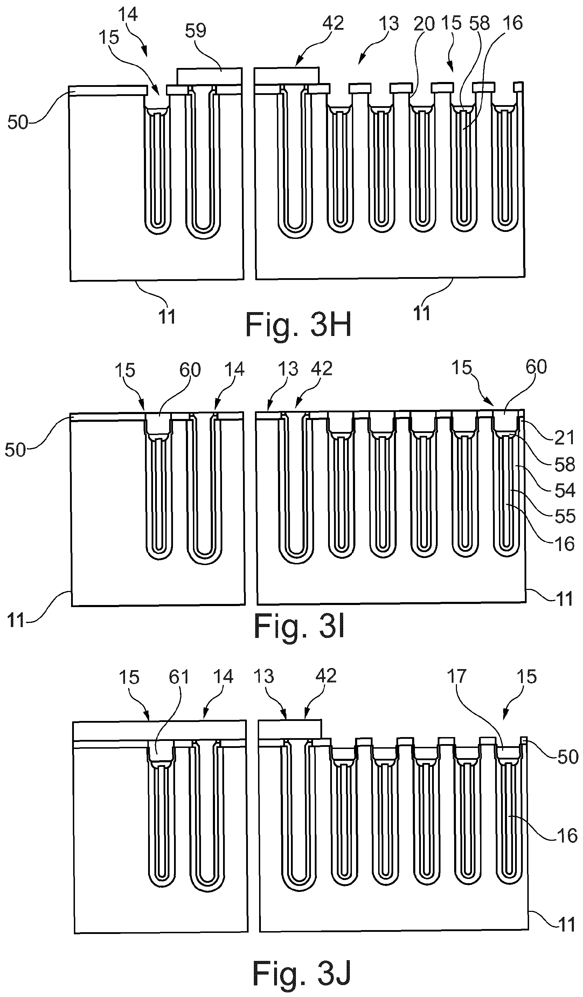

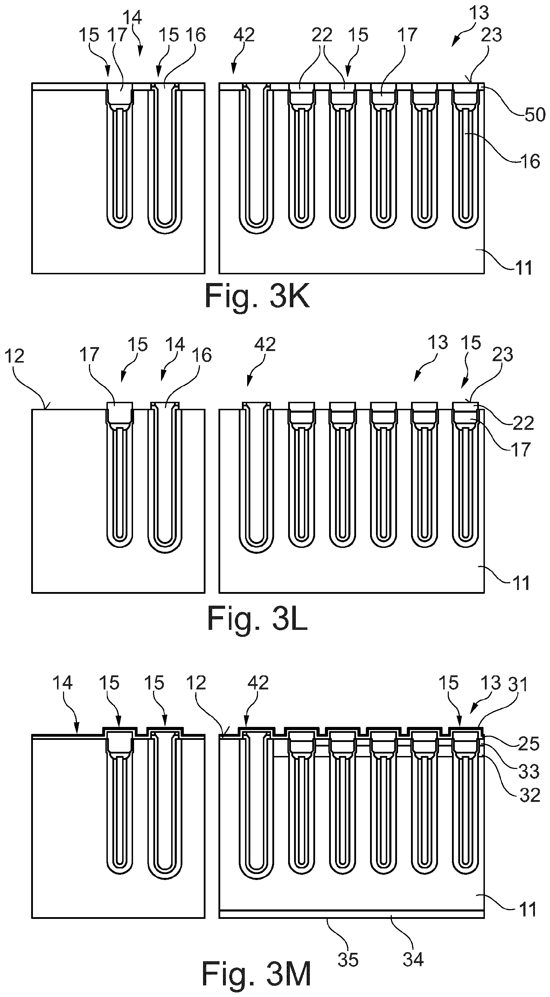

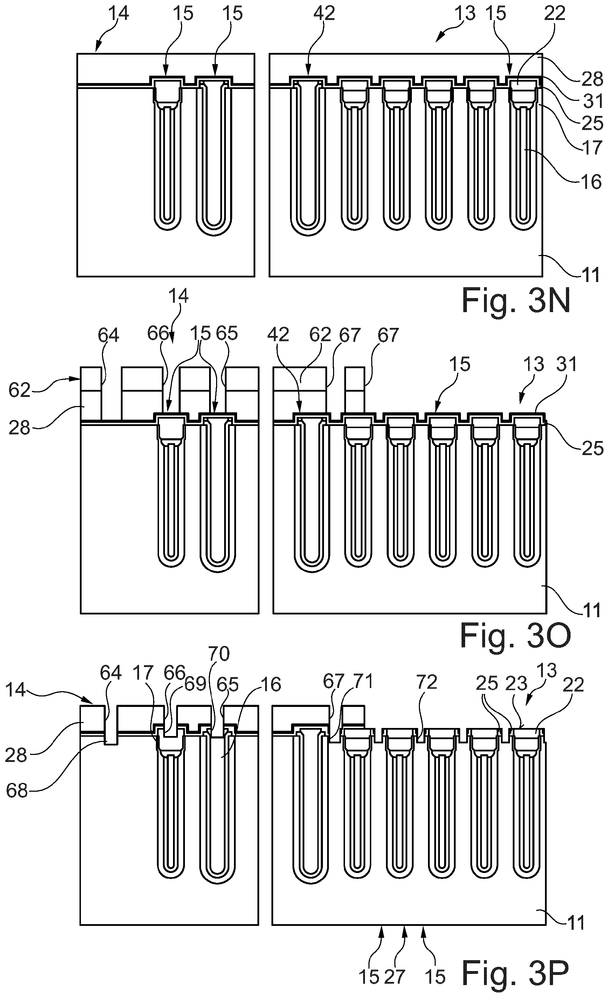

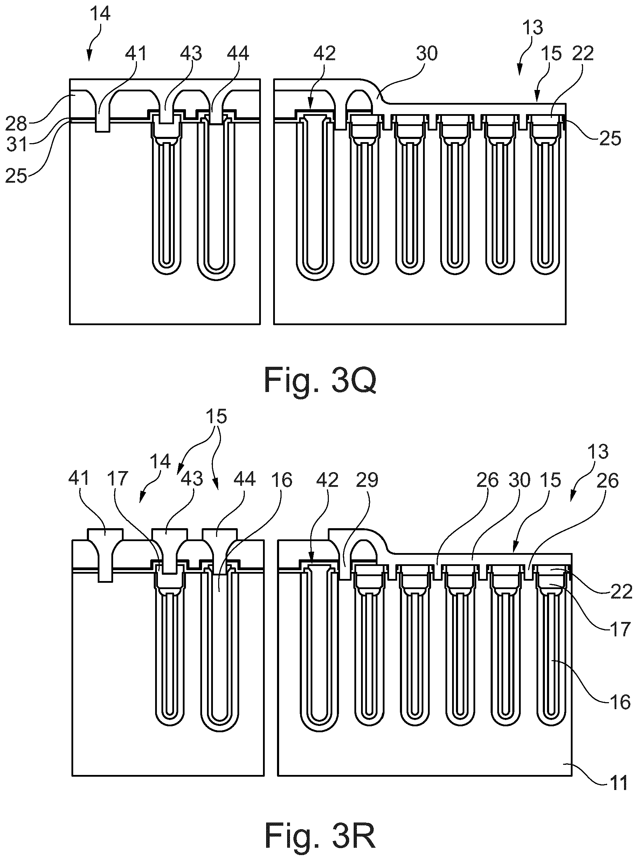

A method of fabricating a contact to a semiconductor substrate will now be described with reference to figure 3. This method may be used to fabricate the first contacts 26 to the mesas 27 of the transistor device 10 described and illustrated in figures 1 and 2 and may be also used to fabricate one or more of the contacts 29, 41, 43, 44 to the edge region 14 or to one or more structures located in the edge region 14 of the semiconductor substrate 11 described and illustrated in figures 1 and 2.

Referring to figure 3A, a semiconductor substrate 11 is provided. The semiconductor substrate 11 may be formed of silicon and may comprise one or more monocrystalline silicon layers, e.g. one or more epi layers grown on a bulk silicon material. A layer of a first mask material 50 is deposited on the first major surface 12 and a layer of a second mask material 51 is deposited on the first mask material 50. The first mask material 50 may be a hard mask material, such as silicon nitride and the second mask material may be a hard mask material, such as silicon oxide, or a soft mask material, for example photoresist. The second and first masks 51, 50 are patterned to form a plurality of openings 52, 53 each of which is sized, shaped and located for forming a trench 15, 42. The openings 52, which are to be located in the active area 13 may have an elongate stripe-like structure and extend substantially parallel to another. The outermost trench opening 53 may have a different structure, for example may be wider and may have a form other than a stripe-like trench, for example, a continuous ring type trench 42 that laterally surrounds the openings 52.

Referring to figure 3B, the trenches 15, 42 are formed in the first major surface 12 of the semiconductor substrate 11 through the openings 52, 53, for example by etching, and then the upper second mask 51 removed.

Referring to figure 3C, a first dielectric material 18 is deposited as a layer which lines the sidewalls 20 and base 19 of the trenches 15, 42 and which extends over the first hard mask 50 that remains on the first major surface 12 of the semiconductor substrate 11. In some embodiments, the first dielectric material 18 has two sublayers, a first sublayer 54 which is in contact with the semiconductor substrate 11 and a second sublayer 55 which extends over the first mask material 50 and over the first sublayer 54. The first sublayer 54 may be formed by thermal growth to form a layer of silicon oxide The second sublayer 55 may be deposited, for example by a TEOS (Tetra Ethyl Ortho Silicate) process or atomic layer deposition (ALD). The first and second sublayers 54, 55 have a thickness such that the second sublayer surrounds an unoccupied gap at the centre of the respective trenches 15, 42.

Then, referring to figure 3D, electrically conductive material 56, for example polysilicon, is inserted into the gaps in the trenches 15, 42 which are unoccupied by the first and second sublayers 54, 55. A planarisation process may be carried out to form a planar surface which comprises regions of the second sublayer 55 and of the conductive material 56.

Referring to figure 3E, a third mask 57 is deposited which covers the edge region 14 and which is structured so as to have an opening 49 which exposes the entire active area 13. The third mask may be formed of photoresist. Using this third mask 57, the conductive material 56 is selectively removed from an upper portion of each of the trenches 15, 42, for example by selective etching. In selective removal, the ratio of the removal rate of one material, in this case the conductive material 56, over the removal rate of another material, in this case the second sublayer 55, is at least 10: 1.

Referring to figure 3F, the third mask 57 is removed and the second sublayer 55 may be partially removed. The second sublayer 55 is removed from the first mask layer 50, from the region of the conductive material 56 that protrudes above the first major surface above the edge trench 42 and from the upper portion of the trenches 15 in the active area 13. Furthermore, a portion of the first sublayer 54 is removed from the upper portion of the sidewall 20 of the trenches 15 and such that an upper portion of the field plate 16 is exposed and protrudes from the first sublayer 54 and second sublayer 55 within the trench 15. This partial removal of the second sublayer 55 may be carried out using a wet etching process.

Referring to figure 3G, a fifth electrically insulating layer 58 is deposited which fills the upper portion of the trenches 15 and the exposed side wall of the field plate 16 positioned in the edge trench 42. The fourth electrically insulating layer 58 may also have two sublayers, a first silicon oxide layer that is formed by thermal oxidation and a larger second sublayer which fills the trenches 15, 42 may be deposited by high density plasma deposition, for example. A planarisation process may be carried out, for example by CMP (Chemical Mechanical Polishing), whereby the first mask layer 50, which is formed of silicon nitride, acts as an etch stop, against the silicon oxide of the first mask layer 50. The planarized surface comprises regions of the first mask, regions the fifth electrically insulating layer 58 in the trenches 15 and regions of the conductive material 56 in the trench 42.

Referring to figure 3H, a further mask 59 is applied which covers the trenches which are not intended to have a gate electrode, for example the trench 42. The fourth electrically insulating layer 58 is removed from the upper portion of the remaining trenches 15 to depth such that the field plate 16 is covered by a portion of the fifth electrically insulating layer 58. The side wall 20 in the upper portion of the trenches 15 is exposed. This removal process may be carried out in the active area 13 as well as in the edge region 14. A wet etch may be used.

Referring to figure 3I, the gate dielectric 21 is formed on the exposed portion of the sidewall 20 of the trenches 15. Then, the trenches 15 are filled with electrically conductive material 60, e.g. polysilicon, to form the gate electrode 17. The third mask 59 is removed. A further planarisation process may be carried out. At this stage, the conductive material 60 for the gate electrodes 17 has an upper surface which is coplanar with the first mask material 50 and, therefore, located above the first major surface 12 of the semiconductor substrate 11. The upper surface of the field plate 16 in the trench 42 is also located in a plane above that of the first major surface 12 and is coplanar with the conductive material 60 for the gate electrodes and the first mask 50.

Referring to figure 3J, a fourth mask 61 is formed which covers the edge region 14 including the trenches 42 without field plates and also the portion of the trench 15 including the gate electrode 17 which is located in the edge region 14 and which is not shown in figure 3J The active area 13 is exposed from the fourth mask 61. In some embodiments, he upper portion of the electrically conductive material 60 for the gate electrodes 17, which may be polysilicon, is removed from the exposed trenches 15 in the active area 13 such that the upper surface of the gate electrode 17 is located below the first major surface 12 and is located within the trench 15. In other embodiments, for example if the first insulating layer 22 comprises a thermally grown oxide, the upper surface of the gate electrode 17 may not be located below he first major surface 12, and may be substantially coplanar with the first major surface 12. The electrically conductive material 60 may be selectively removed, for example by selective etching. The mask 50 remains on the first major surface 12.

Referring to figure 3K, the mask 61 is removed. Then, first insulating layer 22 is deposited and fills the openings 52 in the first mask 50 which expose the trenches 15. The first insulating layer 22 covers the upper surface of the gate electrode 17 in the active area 13. The first insulating layer 22 may be silicon oxide. A planarisation process is carried out and the first mask 50 acts as an etch stop. The planarised surface comprises the upper surface of the portions of the first electrically insulating layer 22 located in the openings 52 of the mask 50 and the mask 50 and the electrically conductive material 16 located in the trench 42. The upper surface 23 of the first electrically insulating layer 22 is located in a plane above that of the first major surface 12.

Referring to figure 3L, the first mask 50 is then removed. For example, a wet etch suitable for removing silicon nitride can be used. As discussed above, the separate portions of the first electrically insulating layer 22 are located above each of the trenches 15 and have a lateral shape corresponding to the shape of the trenches 15, i.e. an elongate stripe-like shape The portions of the first electrically insulating layer 22 protrude above the first major surface 12. The edge trenches 42 and portions of the trenches 15 in the edge region 14 also have an upper surface which is located above the first major surface 12. In one portion of the trenches 15 comprising the gate electrode 17, which is located in the edge region 14, the gate electrode 17 protrudes above the first major surface 12. In another portion of the trenches 15 that is located in the edge region 14, the gate electrode 17 is omitted to that the field plate 16 located at the base of the trench 15 extends to the first major surface. In the edge trench 42 comprising the field plate 16, the conductive material of the field plate 16 and portions of the second sublayer 55 protrude above the first major surface 12.

Figures 3A to 3K illustrate one method of fabricating the structure sown in figure 3L and in particular the separate portions of the first electrically insulating layer that re located on or partially in the upper portion of the trenches 15 that comprise a gate electrode 17 and field plate 16. However, other methods may be used to fabricate the structure shown in figure 3L so that the methods described with reference to figures 3A to 3K are optional.

Referring to figure 3M, then the body region 32 is formed by implanting dopants of the second conductivity type into the first major surface 12, and the source region 33 is formed by implanting dopants of the first conductivity type into the first major surface 12 such that the source region 33 is positioned within the body region 32. The body 32 region forms a pn junction with the underlying portion of the semiconductor substrate 11 which provides the drift region of the transistor device 10. The drain region 34 of the transistor device 10 may be provided by a region at the second major surface 35 of the semiconductor substrate 11, which opposes the first major surface 12. The drain region 34 is doped with the first conductivity type. The source region 33 and the drain region 34 are more highly doped than the drift region.

In other embodiments, the body region, source region and drain region are formed in the semiconductor substrate 11 before the formation of the trenches 15 in the semiconductor substrate 11.

The second insulating layer 25 is then deposited onto the first major surface 12 and covers the portions of the first electrically insulating layer 22 and the conductive material 16 in the trenches 15 and edge trenches 42. The second insulating layer 25 may be formed of silicon oxide. A fourth electrically insulating layer 31 is deposited over the second insulating layer 25. The fourth electrically insulating layer 31 is formed of a material which can act as an etch stop. In some embodiments, the fourth electrically insulating layer 31 is formed of silicon nitride. The second insulation layer 25 and the fourth electrically insulating layer 31 are formed over the entire active area 13 and edge region 14.

Referring to figure 3N, a third electrically insulating layer 28 is deposited which extends over the active area 13 and edge region 14. The third electrically insulating layer may comprise two or more sublayers. In one embodiment, the third electrically insulating layer 28 comprises a silicon oxide sublayer deposited by a TEOS process and BPSG (Borophosphosilicate glass) sublayer on the TEOS layer.

Referring to figure 3O, a mask 62 is deposited onto the third electrically insulating layer 28. The mask 62 may be a soft mask formed of photoresist. The mask 62 may be structured to provide a second opening 63 which exposes the active area 13 and, which in some embodiments, exposes the entire active area 13. The mask 62 may include a third opening 64, which is positioned above the semiconductor substrate 11 in the edge region 14 and which may be used to form a contact to the drain region, a fourth opening 65 which is positioned above the trench 42 comprising the field plate 16 and a fifth opening 66 which is positioned above the portion of the trench 15 including the gate electrode 17 which is located in the edge region 14. The mask 62 may include a sixth opening 67 which is positioned laterally outboard of the outermost active trench 15. The sixth opening 67 may be used to from a contact to the body region at a position that is laterally outboard of the source region.

The mask 62 is used to structure the underlying third electrically insulating layer 28 by, for example, etching in order to remove third electrically insulating layer 28 entirely from the active area 13. The mask 62 is used to structure the underlying third electrically insulating layer 28 so as to expose a portion of the fourth electrically insulating layer above the semiconductor substrate in the edge region 14 at the base of the third opening 64, above the trench 15 including the gate electrode 17 in the edge region 14 at the base of the fifth opening 66, above the trench 42 including field plate 16 at the base of the fourth opening 65 and above the semiconductor substrate 11 adjacent the outermost trench 15 in the active area 13 at the base of the sixth opening 67. The sixth opening 67 may be used to from a contact to the body region at a position that is laterally outboard of the source region. The third electrically insulating layer 28 may be removed by etching, whereby the fourth electrically insulating layer 31 acts as an etch stop.

Referring to figure 3P, the method continues by using the structured third electrically insulating layer 28 as a mask in the edge region 14 and etching the portions of the fourth electrically insulating layer 31 which are exposed at the bottom of the openings 63, 64, 65, 66, 67, removing the underlying second electrically insulating layer 25 and then carrying out an etch to form a recess 68 through the base of the fourth opening 64 which extends into the semiconductor substrate 11 in the edge region 14, a recess 69 through the base of the sixth opening 66 which extends into the upper portion of the gate electrode 17, a recess 70 through the base of the fifth opening 65 into the conductive material of the field plate 16 and a recess 71 at the base of the seventh opening 67.

During this etch process, in the active area 13, the second electrically insulating layer 25, which covers the sidewalls 24 and upper surface 23 of the first portions of the first electrically insulating layer 22, is removed from the upper surface 23 and a central portion of the second electrically insulating layer 25 and the fourth electrically insulating layer 31 that is located above the mesa 27 is removed. The side walls 24 of the portions of the first electrically insulating layer 22 remain covered by the second electrically insulating layer 25. This structure of the portions of the first electrically insulating layer 22 that are located on the gate electrode 17 and that protrude above the first major surface 12 in combination with the second electrically insulating layer 25 that is located on the side walls 24 of these portions acts as a mask for producing a self-aligned contact recess 72 in the mesa 27 formed between adjacent ones of the trenches 15. The portions of the first electrically insulating layer 22 and the portions of the second electrically insulating layer 25 that extend between neighbouring portions of the first electrically insulating layer 22 and the contact 26 remain in the final transistor device 10 and have an insulating function in the final transistor device 10.

Thus, in a single etch process, in the edge region 14, the contact recesses 68, 69, 70, 71 are formed by means of the mask provided by the third electrically insulating layer 28 to form non-self-aligned contact recesses 68, 69, 70, 71 in the edge region 14, whereas in the active area 13, self-aligned contact recesses 72 are formed without the use of the additional mask 28.

Figure 3Q illustrates the deposition of a conductive layer 30 into the contact recesses 68, 69, 70, 71, 72 which also extends over the first major surface 12. The conductive layer 30 may be formed of tungsten, for example. In some embodiments, the conductive layer 30 comprises two or more sublayers, for example a lower titanium silicide sublayer and tungsten upper sublayer. Before the deposition of the conductive layer 30, an annealing process may be carried out in particular on the third electrically conductive layer 28, for example if this is formed of BPSG.

As shown in figure 3R, the conductive layer 30 is then structured to form separate contacts 41, 43, 44 to the semiconductor substrate 11, to the gate electrode 17 and to the field plate 16 in the edge region 14 and to form a separate lateral portion of the conductive layer 30 in the active area 13 which electrically connects the contacts 26, 29 to one another.

Alternatively, the conductive layer 30 may be deposited in a structured form, i.e. the separate contacts 41, 43, 44 to the semiconductor substrate 11, to the gate electrode 17 and to the field plate 16 in the edge region 14 and the lateral portion of the conductive layer 30 in the active area 13 which electrically connects the contacts 26, 29 to one another are deposited so that a subsequent structuring step is omitted.

At least portions of the fourth electrically insulating layer 31 (which may serve as an etch stop, as described in further detail above) may remain on the second electrically insulating layer 25 after the method as described in context with Figure 3 is completed (e.g., may completely remain in the edge termination area and/or may partially remain in the active area).

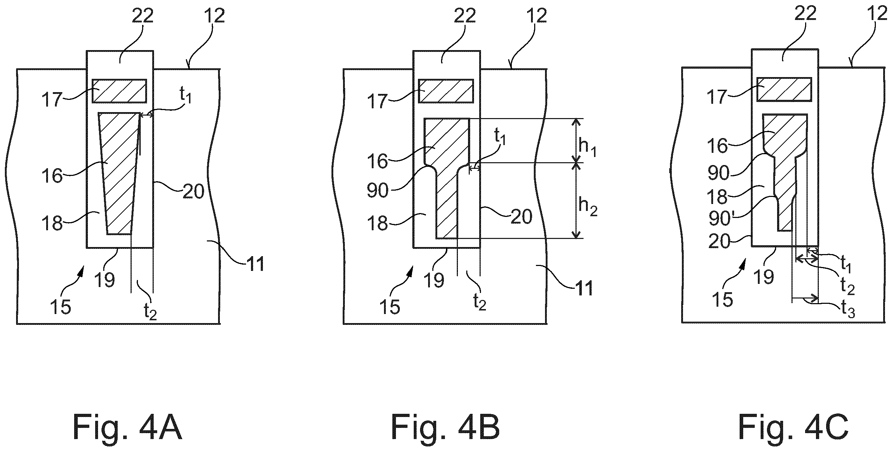

In figures 1 to 3, the first dielectric material 18 on the sidewall 20 and base of the trench 15 has a substantially uniform thickness so that the field plate 16 has a substantially uniform width. Figure 4, which includes figures 4A to 4C, illustrates cross-sectional views of a trench 15 with a dielectric 18 that has a non-uniform width on the side wall 20 of the trench 15. These forms of the first dielectric material 18 may be used in place of the uniform thickness of the first dielectric material 18 of the semiconductive devices 10 illustrated in figures 1 to 3.

Referring to figures 4A to 4C, the first dielectric material 18 in the trench 15 has a first thickness t1 on the side wall 20 in an upper portion of the trench 15 and a second thickness t2 on the side wall 20 in the lower portion of the trench 15. The second thickness t2 of the dielectric 18 in a lower portion of trench 15 is greater than the thickness t1 in the upper portion of the trench 15. The field plate 16 has a larger outer width w1 in the upper portion of the trench 15 than its width w2 in the lower portion of the trench 15.

In some embodiments, the thickness t₁ ≤ 1.15 times the thickness t₂ and consequently the thickness t₁ is greater than typical process variations. In some embodiments, the difference is greater so that t₁ ≤ 1.2 t₂ or t1 ≤ 1.5 t₂. In some embodiments, the difference is greater so that t₁ ≤ 3 t₂ or t₁ ≤ 4 t₂.

Referring to figure 4A, the field plate 16 may have a tapering structure such that its width decreases from the top of the trench 15 towards the base 19 of the trench 15. The first dielectric material 18 has the opposite structure such that it's thickness on the side wall 20 continuously increases in a direction from the first major surface 12 towards the base 19 of the trench 15. The first dielectric material 18 has a thickness t1 on the side wall 20 at the first major surface 12 and decreases continuously to a thickness t2 on the side wall 20, whereby t1 < t2. The field plate 16 can be considered to have a funnel shape.

Referring to figure 4B, in some embodiments, the first dielectric material 18 comprises an abrupt transition from the first to the second thickness that forms a step 90 so that the first dielectric 18 can be considered to have a stepped shape. In some embodiments, the first dielectric material 18 has the smaller thickness t1 over a first height h1 of the trench 15 in the upper portion and the larger thickness t2 over a second height h2 of the trench 15 in the lower portion.

The field plate 16 16 may also have an abrupt transition between a larger outer width w1 in the upper portion of the trench 15 and a smaller outer width w2 towards the lower portion of the trench 15. The field plate 16 can be considered to have a step in its side wall corresponding to the step 90 formed in the first dielectric material 18. The field plate 16 can be considered to have a T-shape in cross-section.

Referring to figure 4C, in an embodiment, the field plate 16 and the first dielectric material 18 may also have more than one step 90. Figure 4C illustrates an embodiment in which the field plate 16 has two steps 90, 90' such the first dielectric material 18 has three different thicknesses between the outer surface of the side wall of the field plate 16 and the side wall 20 of the trench 11. The thickness increases stepwise incrementally from the first major surface 12 towards the base 19 of the trench 15. In the upper portion of the side wall 20, the first dielectric material 18 has a thickness t1, in the middle portion a thickness t2 and in the third portion a thickness t3, whereby t1 < t2 < t3. The side face of the field plate 16 has two steps 90, 90' such it has three different widths and such that the outer width of the field plate 16 decreases stepwise from the first major surface 12 towards the base 19 of the trench 15.

The field plate 16 with the shape shown in any one of figures 4A to 4C may be fabricated by first performing the method described with reference to figures 3A to 3C. After forming the first dielectric layer 18 on the side wall 20 and base 19 of the trench 15, as shown in figure 3C, the method continues by filling the trench 15 with the conductive material 56, and then removing an upper portion of the conductive material 56 from an upper portion of the trench 15 and exposing the first dielectric material 18 arranged on the upper portion of the side wall 20 of the trench 15.

A portion of this exposed first dielectric material 18 is removed and the thickness of the exposed first dielectric material 18 arranged on the side wall of the upper portion of the trench 15 is reduced. The side wall 20 in the upper portion of the trench 15 remains covered by a thinner layer of the first dielectric material 18. Conductive material 56 is inserted into the trench 15 and the upper portion of the trench 15 is filled with the conductive material 56 to from a field plate 16 with a wider upper portion and narrower lower portion. Consequently, the first dielectric material 18 has a smaller thickness in the upper portion and a larger thickness in the lower portion of the trench 15 and may have a stepped profile. The method then continues as described with reference to figures 3D to 3R.

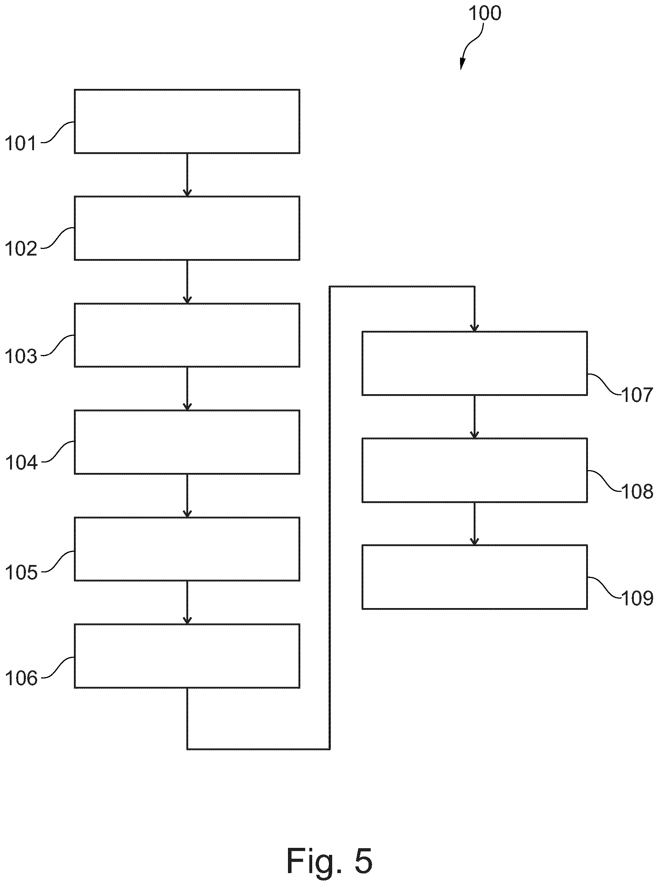

Figure 5 illustrates a flow diagram 100 of a method for fabricating a contact to a semiconductor device. The method may be used to fabricate a contact to an active area of a semiconductor device, for example a contact to a source region and body region of a transistor device. The method may be used to fabricate the contact 26 shown in and described with reference to Figures 1 and 2.

In box 101, a semiconductor substrate comprising a first major surface is provided. In box 102, a first hard mask is formed on the first major surface of the semiconductor substrate. In box 103, a first opening is formed in the first hard mask.

In box 104, a trench is formed in the first major surface of the semiconductor substrate in the first opening of the first hard mask, the trench comprising a side wall and base. A field plate is formed in the lower portion of the trench and a gate electrode in the upper portion of the trench above the field plate. The gate electrode is exposed in the first opening of the first hard mask.

In box 105, a first electrically insulating material is deposited into the first opening in the first hard mask.

In box 106, the first hard mask is selectively removed such that a portion of the first electrically insulating layer that remains protrudes above the first major surface of the semiconductor substrate. If two or more trenches are provided, one portion of the first electrically insulating layer is located above each trench and is spaced apart from the other portions of the first electrically insulating layer.

In box 107, a second electrically insulating layer is deposited over the first major surface of the semiconductor substrate and over the portion of the first electrically insulating layer.

In box 108, an etch process is performed and a first recess is formed that extends through the second electrically insulating layer and into the first major surface of the semiconductor substrate adjacent the trench.

In box 109, electrically conductive material is inserted into the first recess to form a contact to the semiconductor substrate. The contact is spaced apart from neighbouring portions of the first electrically insulating layer by the second electrically insulating layer.

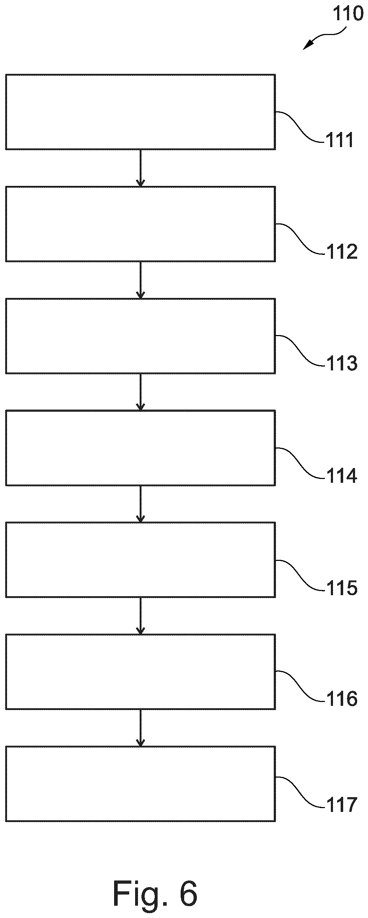

Figure 6 illustrates a flow diagram 110 of a method for fabricating a contact to an active area and to an edge region of a semiconductor substrate. The method may be used to fabricate a contact to a source region and body region of the active area of a transistor device and to a field plate and gate electrode at a position in the edge region. The method may also be used to form a contact to the semiconductor substrate in the edge region. The method may be used to fabricate the contacts 26 and 29 shown in and described with reference to Figures 1 and 2.

In box 111, a semiconductor substrate is provided that has a first major surface, an active area and an edge region that laterally surrounds the active area. One or more trenches are located in the active area and, optionally, in the edge region.

In box 112, a portion of a first electrically insulating layer is formed above each of the trenches that are located in the semiconductor substrate in at least the active area. The portions of the first electrically insulating layer are spaced apart from one another.

In box 113, a second electrically insulating layer is formed over the portions of the first electrically insulating layer and over the first major surface in the active area and in the edge region.

In box 114, a third electrically insulating layer is formed on the first electrically insulating layer in the edge region only, the active area is free of the third electrically insulating layer.

In box 115, a structured soft mask is formed on the third electrically insulating layer and removing the third electrically insulating layer above at least one discrete region of the first major surface of the semiconductor substrate in the edge region.

In box 116, an etch process is performed and the third electrically insulating layer and the second electrically insulating layer are removed from the at least one discrete region and an underlying structure in the edge region is exposed to form a non-aligned contact recess in the edge region, and, adjacent to the portions of the first electrically insulating layer, the second electrically insulating layer and a portion of the semiconductor substrate is removed to form a self-aligned contact recess in the active area, wherein the portions of the first electrically insulating layer above the trenches in the semiconductor substrate act as a mask.

In box 117, electrically conductive material is inserted into the non-aligned contact recess in the edge region and into the self-aligned contact recess in the active area to form a self-aligned contact in the active area and a non-aligned contact in the edge region of a semiconductor substrate.

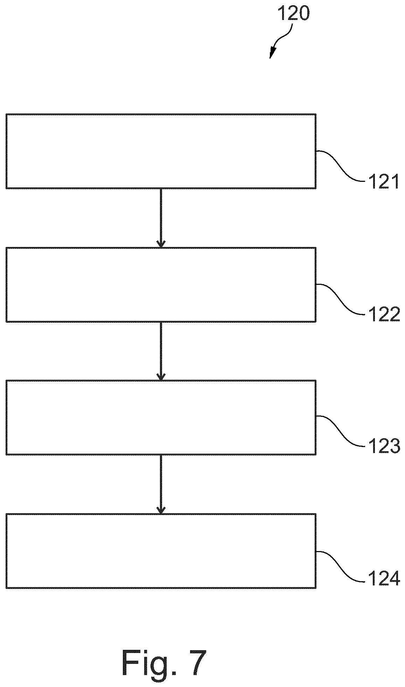

Figure 7 illustrates a flow diagram 120 of a method for fabricating a contact to an active area of a semiconductor device. The method may be used to fabricate a contact to an active area of a semiconductor device, for example a contact to a source region and body region of a transistor device. The method may be used to fabricate the contact 26 shown in and described with reference to Figures 1 and 2.

In box 121 a semiconductor substrate comprising a first major surface, a trench in the first major surface, a field plate in the lower portion of the trench and a gate electrode in the upper portion of the trench above the field plate, and a region of a first electrically insulating layer that is positioned on the gate electrode in the trench and that protrudes above the first major surface of the semiconductor substrate is provided.

In box 122, a second electrically insulating layer is deposited over the first major surface and over the region of the first electrically insulating layer. Optionally a fourth electrically insulating layer which may be formed of a material suitable for forming an etch stop is deposited over the second electrically insulating layer.

In box 123, an etch process is performed and a first recess is formed that extends through the second electrically insulating layer and into the first major surface of the semiconductor substrate adjacent the trench.

In box 124, electrically conductive material is inserted into the first recess to form a contact to the semiconductor substrate.

To summarise, methods for fabricating self-aligned contacts in the active area of a device, e.g. a transistor device. The gate structure is used to create a topology that is used to form these contacts to the mesa. The gate structure may be used in combination with a nitride layer that acts as an etch stop. The contacts to the field plate and gate electrode, and the contacts to the drain may be fabricated by means of lithography and be non-aligned contacts. The self-aligned contacts to the mesas in the active area and the non-aligned contacts in the edge region may be fabricated using some of the same processes so as to simplify and speed up manufacturing of the transistor device.

By using the self-aligned process, the contact may be positioned more reliably at the centre of the mesa. Thus, the threshold voltage (VT), the RON, the gate capacitance (QGS, QGD), the avalanche robustness and other device parameters are better controlled and may be improved.

Although the present disclosure is not so limited, the following numbered examples demonstrate one or more aspects of the disclosure.

### Examples

1. Method for fabricating a contact to a semiconductor device, the method comprising:
   providing a semiconductor substrate comprising a first major surface;
   forming a first hard mask located on the first major surface;
   forming a first opening in the first hard mask;
   forming one or more trenches located in the first major surface of the semiconductor substrate in the first opening of the first hard mask, the one or more trenches comprising a side wall and base, forming a field plate in the lower portion of the one or more trenches and a gate electrode in the upper portion of the one or more trenches above the field plate, wherein the gate electrode is exposed in the first opening of the first hard mask;
   depositing a first electrically insulating material into the first opening in the first hard mask;
   selectively removing the first hard mask such that a portion of the first electrically insulating layer that remains protrudes above the first major surface of the semiconductor substrate;
   depositing a second electrically insulating layer over the first major surface and over the portion of the first electrically insulating layer;
   performing an etch process and forming a first recess that extends through the second electrically insulating layer and into the first major surface of the semiconductor substrate adjacent the one or more trenches,
   inserting electrically conductive material into the first recess to form a contact to the semiconductor substrate.
2. The method of example 1, wherein the portion of the first electrically insulating layer forms a second hard mask.
3. The method of example 1 or example 2, wherein the contact is self-aligned.
4. The method of any one of examples 1 to 3, wherein the depositing a first electrically insulating material into the first opening in the first hard mask comprises:
   depositing the first electrically insulating layer over the first hard mask and into the first opening, and then
   performing a planarizing process,
   wherein the first hard mask acts as an etch stop and a planar surface comprising material of the first head mask and the first electrically insulating layer is formed.
5. The method according to any one of examples 1 to 4, wherein the semiconductor substrate comprises an active area and an edge region that laterally surrounds the active area; wherein the first hard mask and the second electrically insulating layer are deposited on the active area and on the edge region and the trench is at least partially located in the active area.
6. The method according to example 5, further comprising:
   after depositing the second electrically insulating layer:
   depositing an etch stop layer onto the second electrically insulating layer.
7. The method according to example 6, further comprising:
   depositing a third electrically insulating layer over the second electrically insulating layer and on the active area and on the edge region;
   forming a structured first soft mask on the third electrically insulating layer, wherein the first soft mask comprises a second opening that is sized and shaped to expose the entire active area and a third opening above the edge region;
   structuring the third electrically insulating layer using the structured first soft mask and forming a third opening in the third electrically insulating layer that is located above the active area and a fourth opening that is located above the first major surface in the edge region.
8. The method according to example 5,
   wherein, when performing the etch process, in the fourth opening a second recess is formed which extends into the first major surface of the semiconductor substrate in the edge region, and
   wherein, when inserting electrically conductive material into the first recess in the active area, the electrically conductive material is also inserted into the second recess.
9. The method according to claim 7 or claim 8, wherein third opening in the third electrically insulating layer exposes the entire active area
10. The method according to any one of examples 5 to 9, wherein the structured first soft mask comprises a fifth opening located above the edge region,
   wherein when performing the etch process, a third recess is made in the fifth opening which exposes a field plate located in a portion of the trench that is located in the edge region, and
   when inserting electrically conductive material into the first recess in the active area, the electrically conductive material is also inserted into the third recess.
11. The method according to any one of examples 5 to 10, wherein the structured first soft mask comprises a sixth opening located above the edge region,
   wherein when performing the etch process, a fourth recess is made in the sixth opening which exposes a portion of the gate electrode located in the trench.
12. The method according to claim 11, when inserting electrically conductive material into the first recess in the active area, the electrically conductive material is also inserted into the fourth opening and provides a contact to the gate electrode.
13. The method according to any one of examples 5 to 12, wherein in the edge region the gate electrode is coplanar with the first major surface or protrudes above the first major surface of the semiconductor substrate.
14. The method according to any one of examples 1 to 13, wherein to form the field plate in the trench, the method further comprises:
   forming a field dielectric on the side wall and base of the trench and then,
   inserting conductive material into the trench.
15. The method of example 14, wherein in the edge region the field plate is coplanar with the first major surface or protrudes above the first major surface of the semiconductor substrate.
16. The method according to any one of examples 1 to 15, wherein to form the gate electrode, the method further comprises:
   forming a third soft mask that covers the edge region and exposes the active area, selectively removing the conductive material from an upper portion of the trench to form a field plate;
   removing a portion of the field dielectric on the upper portion of the trench;
   inserting electrically insulating material into the trench;
   carrying out a planarization process using the first mask as an etch stop;
   removing the electrically insulating material from an upper portion of the trench and exposing an upper portion of the sidewall; wherein the field plate is covered by the remaining electrically insulating material;
   forming a gate dielectric on the exposed portion of the sidewall;
   inserting conductive material into the trench to form the gate electrode,
   carrying out a further planarising process;
   removing an upper portion of electrically conductive material to recess the gate electrode.
17. The method according to any one of examples 1 to 16, wherein the semiconductor substrate comprises a first conductivity type and a drain region at a second major surface that opposes the first major surface and the method further comprises:
   implanting dopants of a second conductivity type that opposes the first conductivity type into the first major surface to form a body region of a transistor device,
   implanting dopants of a first conductivity type into the first major surface to form a source region of a transistor device.
18. The method of example 17, wherein the source region and body region may be formed before or after forming the trench comprising the field plate and gate electrode.
19. The method according to any one of examples 1 to 18, wherein the recess has side walls and a base and the side walls are spaced apart from the side wall of the trench.
20. The method according to any one of examples 1 to 19, wherein the field plate is electrically insulated from the substrate and from the gate electrode.
21. A transistor device, comprising:
   a semiconductor substrate having a first major surface, an active area and an edge region that laterally surrounds the active area;
   a trench in the first major surface that is located at least partly in the active area, a field plate in the lower portion of the trench and a gate electrode in the upper portion of the trench above the field plate;
   a first self-aligned contact into the first major surface of the semiconductor substrate laterally adjacent to and spaced apart from the trench;
   wherein in the active area an upper surface of the gate electrode is in contact with a first electrically insulating layer only,
   wherein the first electrically insulating layer protrudes above the first major surface and has an upper surface and side walls that extend from the upper surface to the first major surface of the semiconductor substrate and wherein a second electrically insulating layer is located on the side walls of the first electrically insulting layer and the upper surface of the first electrically insulating layer is free of the second electrically insulating layer.
22. The transistor device according to example 21, wherein in the edge region, a second electrically insulating layer is arranged on the first major surface and a third electrically insulating layer is arranged on the second electrically insulating layer and wherein in the active region the second electrically insulating layer is located on the first major surface, the active region being free of the third electrically insulating layer,
   wherein in the active area, the first contact extends through the second electrically insulating layer and in the edge region a second contact extends through the second and third electrically insulating layers.
23. The transistor device of example 22, wherein the third electrically insulating layer has a thickness that is at least twice the thickness of the second electrically insulating layer.
24. The transistor device according to example 22 or example 23,
   wherein the second contact further extends into the semiconductor substrate, or
   wherein the trench extends into the edge region and in the edge region the gate electrode extends to, or protrudes above, the first major surface, wherein the second contact contacts the gate electrode, or
   wherein the trench extends into the edge region and the second contact contacts a field plate located in an edge trench located in the edge region, wherein the field plate that extends to, or protrudes above, the first major surface.
25. The transistor device according to any one of examples 22 to 24, further comprising a fourth insulating layer that is located on the second electrically insulating layer that acts as an etch stop.
26. A method of forming a contact to an active area of a semiconductor substrate and a contact to an edge region of the semiconductor substrate, the method comprising:
   providing a semiconductor substrate having a first major surface, an active area and an edge region that laterally surrounds the active area;
   forming portions of first electrically insulating layer above trenches in the semiconductor substrate in at least the active area;
   forming a second electrically insulating layer over the portions of the first electrically insulating layer and the first major surface in the active area and in the edge region;
   forming a third electrically insulating layer on the second electrically insulating layer in the edge region, the active area being free of the third electrically insulating layer;
   forming a structured soft mask on the third electrically insulating layer and removing the third electrically insulating layer to form an opening above at least one discrete region of the semiconductor substrate in the edge region;
   performing an etch process and removing the third electrically insulating layer and the second electrically insulating layer from the at least one discrete region and exposing an underlying structure in the edge region to form a non-aligned contact recess in the edge region, and, adjacent to the portions of the first electrically insulating layer, removing the second electrically insulating layer and a portion of the semiconductor substrate to form a self-aligned contact recess in the active area, wherein the portions of the first electrically insulating layer above the trenches in the semiconductor substrate acts as a mask;
   inserting electrically conductive material into the non-aligned contact recess in the edge region to from a non-aligned contact and into the self-aligned contact recess in the active area to form a self-aligned contact.
27. The method of example 26, wherein the forming a third electrically insulating layer on the first electrically insulating layer in the edge region only comprises:
   forming a structured soft mask on the third electrically insulating layer, removing the third electrically insulating layer from the active area entirely and removing the third electrically insulating layer from at least one discrete region of the first major surface of the semiconductor substrate in the edge region.
28. A method comprising:
   providing a semiconductor substrate comprising a first major surface, a trench in the first major surface, a field plate in the lower portion of the trench and a gate electrode in the upper portion of the trench above the field plate and a region of a first electrically insulating layer that is positioned on the gate electrode in the trench and that protrudes above the first major surface of the semiconductor substrate;
   depositing a second electrically insulating layer over the first major surface and over the region of the first electrically insulating layer;
   performing an etch process and forming a first recess that extends through the second electrically insulating layer and into the first major surface of the semiconductor substrate adjacent the trench,
   inserting electrically conductive material into the first recess to form a contact to the semiconductor substrate.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. Method for fabricating a contact to a semiconductor device, the method comprising:
providing a semiconductor substrate (11) comprising a first major surface (12);
forming a first hard mask (50) located on the first major surface (12);
forming a first opening (52) in the first hard mask (50);
forming one or more trenches (15) in the first major surface (12) of the semiconductor substrate (11) in the first opening (52) of the first hard mask (50), the one or more trenches (15) comprising a side wall (20) and base (19), forming a field plate (16) in the lower portion of the one or more trenches (15) and a gate electrode (17) in the upper portion of the one or more trenches (15) above the field plate (16), wherein the gate electrode (17) is exposed in the first opening (52) of the first hard mask (50);
depositing a first electrically insulating material (22) into the first opening (52) in the first hard mask (50);
selectively removing the first hard mask (50) such that a portion of the first electrically insulating layer (22) remains and protrudes above the first major surface (12) of the semiconductor substrate (11);
depositing a second electrically insulating layer (25) over the first major surface (12) and over the portion of the first electrically insulating layer (22);
performing an etch process and forming a first recess (72) that extends through the second electrically insulating layer (25) and into the first major surface (12) of the semiconductor substrate (11) adjacent the one or more trenches (15),
inserting electrically conductive material into the first recess (72) to form a contact (26) to the semiconductor substrate (11).

2. The method according to claim 1, wherein the semiconductor substrate (11) comprises an active area (13) and an edge region (14) that laterally surrounds the active area (13); wherein the first hard mask (50), the second electrically insulating layer (25) is deposited on the active area (13) and on the edge region (14) and the one or more trenches (15) is at least partially located in the active area (13).

3. The method according to claim 2, further comprising:
after depositing the second electrically insulating layer (25):
depositing an etch stop layer (31) onto the second electrically insulating layer (25).

4. The method according to claim 3, further comprising:
depositing a third electrically insulating layer (28) over the second electrically insulating layer (25) and on the active area (13) and on the edge region (14);
forming a structured first soft mask (62) on the third electrically insulating layer (28), wherein the first soft mask (62) comprises a second opening (63) that is sized and shaped to expose the active area (13) and a third opening (64) above the edge region (14);
structuring the third electrically insulating layer (28) using the structured first soft mask (61) and forming a second opening (63) in the third electrically insulating layer (28) that is located above the active area (13) and a third opening (64) that is located above the first major surface (12) in the edge region (14).

5. The method according to claim 2,
wherein, when performing the etch process, in the third opening (64) a second recess (68) is formed which extends into the first major surface (12) of the semiconductor substrate (11) in the edge region (14), and
wherein, when inserting electrically conductive material into the first recess (72) in the active area (13), the electrically conductive material is also inserted into the second recess (68).

6. The method according to any one of claims 2 to 5, wherein the structured first soft mask (61) comprises a fifth opening (65) located above the edge region (14),
wherein when performing the etch process, a third recess (70) is made in the fifth opening (65) which exposes a field plate (16) located in a portion of the one or more trenches (15) that is located in the edge region (14), and
when inserting electrically conductive material into the first recess (68) in the active area, the electrically conductive material is also inserted into the third recess (70).

7. The method according to any one of claims 2 to 6, wherein the structured first soft mask (61) comprises a sixth opening (66) located above the edge region (14),
wherein when performing the etch process, a fourth recess (69) is made in the sixth opening (66) which exposes a portion of the gate electrode (17) located in the one or more trenches (15).

8. The method according to claim 7, wherein
when inserting electrically conductive material into the first recess (68) in the active area, the electrically conductive material is also inserted into the fourth recess (69) and provides a contact to the gate electrode (17).

9. The method according to any one of claims 2 to 8, wherein to form the field plate (16) in the one or more trenches (15), the method further comprises:
forming a field dielectric (18) on the side wall (20) and base (19) of the one or more trenches (15) and then,
inserting conductive material (56) into the one or more trenches (15).

10. The method according to claim 9, wherein to form the gate electrode (17), the method further comprises:
forming a third soft mask (57) that covers the edge region (14) and uncovers the active area (13),
selectively removing the conductive material (56) from an upper portion of the one or more trenches (15) to form a field plate (16);
removing a portion of the field dielectric (18) on the upper portion of the one or more trenches (15);
inserting electrically insulating material (58) into the one or more trenches (1558);
carrying out a planarization process using the first mask (50) as an etch stop;
removing the electrically insulating material (58) from an upper portion of the one or more trenches (15) and exposing an upper portion of the sidewall (20); wherein the field plate (16) is covered by the remaining electrically insulating material (58);
forming a gate dielectric (21) on the exposed portion of the sidewall (20);
inserting conductive material (60) into the one or more trenches (15) to form the gate electrode,
carrying out a further planarising process;
removing an upper portion of electrically conductive material (60) to recess the gate electrode (17).

11. The method according to any one of claims 1 to 10, wherein the semiconductor substrate (11) comprises a first conductivity type and a drain region (34) at a second major surface (35) that opposes the first major surface (12) and the method further comprises:
implanting dopants of a second conductivity type that opposes the first conductivity type into the first major surface (12) to form a body region (32) of a transistor device (10),
implanting dopants of a first conductivity type into the first major surface (12) to form a source region (33) of a transistor device (10).

12. A transistor device (10), comprising:
a semiconductor substrate (11) having a first major surface (12), an active area (13) and an edge region (14) that laterally surrounds the active area (13);
one or more trenches (15) in the first major surface (12) located at least partially in the active area (13), a field plate (16) in the lower portion of the one or more trenches (15) and a gate electrode (17) in the upper portion of the one or more trenches (15) above the field plate (16);
a first self-aligned contact (26) into the first major surface (12) of the semiconductor substrate (11) at a position laterally adjacent to and spaced apart from the one or more trenches (15);
wherein in the active area (13) an upper surface of the gate electrode (17) is in contact with a first electrically insulating layer (22) only,
wherein the first electrically insulating layer (22) protrudes above the first major surface (12) and has an upper surface (23) and side walls (24) that extend from the upper surface (23) to the first major surface (12) of the semiconductor substrate (11) and wherein a second electrically insulating layer (25) is located on the side walls (24) of the first electrically insulating layer (22) and the upper surface (23) of the first electrically insulating layer (22) is free of the second electrically insulating layer (25).

13. The transistor device according to claim 12, wherein, in the edge region (14), the second electrically insulating layer (25) is arranged on the first major surface (12) and a third electrically insulating layer (28) is arranged on the second electrically insulating layer (25) and wherein, in the active region (13), the second electrically insulating layer (25) is located on the first major surface (12), the active region (13) being free of the third electrically insulating layer (28),
wherein, in the active area (13), the first contact (26) extends through the second electrically insulating layer (25) and in the edge region (14) a second contact (29, 41, 43, 44) extends through the second and third electrically insulating layers (25, 28).

14. The transistor device according to claim 13,
wherein the second contact (29, 41) further extends into the semiconductor substrate (12), or
wherein the one or more trenches (15) extend into the edge region (14) and in the edge region (14) the gate electrode (17) extends to, or protrudes above, the first major surface (12), wherein the second contact (44) contacts the gate electrode (17), or
wherein the one or more trenches (15) extend into the edge region (14) and in the edge region (14) and the second contact (43) contacts a field plate (16) located in the one or more trenches (15) located in the edge region (14), wherein the field plate (16) extends to, or protrudes above, the first major surface (12).

15. A method of forming a contact (26) to an active area (13) of a semiconductor substrate and a contact (41, 43, 44) to an edge region (14) of the semiconductor substrate (11), the method comprising:
providing a semiconductor substrate (11) having a first major surface (12), an active area (13) and an edge region (14) that laterally surrounds the active area (13);
forming portions of first electrically insulating layer (22) above one or more trenches (15) in the semiconductor substrate (11) in at least the active area (13);
forming a second electrically insulating layer (25) over the portions of first electrically insulating layer (22) and the first major surface (12) in the active area (13) and in the edge region (14);
forming a third electrically insulating layer (28) on the second electrically insulating layer (25) in the edge region (14), the active area (13) being free of the third electrically insulating layer (28);
forming a structured soft mask (62) on the third electrically insulating layer (28) and removing the third electrically insulating layer (28) to form an opening (64) above at least one discrete region of the semiconductor substrate (11) in the edge region (14);
performing an etch process and removing the third electrically insulating layer (28) and the second electrically insulating layer (25) from the at least one discrete region and exposing an underlying structure in the edge region (14) to form a non-aligned contact recess (68, 69, 70) in the edge region (14), and, adjacent to the portions of the first electrically insulating layer (22), removing the second electrically insulating layer (25) and a portion of the semiconductor substrate (11) to form a self-aligned contact recess (72) in the active area (13), wherein the portions of the first electrically insulating layer (22) above the one or more trenches (15) in the semiconductor substrate (11) act as a mask;
inserting electrically conductive material (30) into the non-aligned contact recess (68, 69, 70) in the edge region to form a non-aligned contact (41, 43, 44) and into the self-aligned contact recess (72) in the active area (13) to form a self-aligned contact (26).
